# EUROPEAN PATENT APPLICATION

(11) **EP 0 903 378 A1**
(43) Date of publication of application: **24.03.1999**
(21) Application number: 98307509.4
(22) Date of filing: 16.09.1998
(51) Int. Cl.: C08L 83/04, H01L 23/29

(54) **Dielectric gel for protection of electronic modules**

(30) Priority: 19.09.1997 US 934180
(71) Applicant: DOW CORNING CORPORATION, Midland Michigan 48686-0994 (US)
(72) Inventor: Alvarez, Khristopher Edward, Midland, Michigan 48642 (US); Norris, Ann Walstrom, Midland, Michigan 48642 (US); Frazer, Roger Allen, Midland, Michigan 48640 (US); Maxson, Myron Timothy, Sanford, Michigan 48657 (US); Strong, Michael Raymond, Midland, Michigan 48640 (US); Witucki, Beth Ann, Bay City, Michigan 48706 (US); Zhang, Shizhong, Midland, Michigan 48642 (US)
(74) Representative: Hall, Marina

(57) **Abstract**

Polyorganosiloxane gels prepared using compositions curable by a platinum group metal catalyzed hydrosilation reaction are characterized by the presence of a non-reactive silicone fluid. The gel may contain additional components and may also be formulated into a multi-part system.

## Description

This invention relates to organosiloxane gels, having a non-reactive silicone fluid therein, which have less weight loss and improved heat stability, with no appreciable bleed, upon cure.

In many gels used as coating, potting and encapsulating materials, they must maintain adhesion to electronic or electrical components and printed circuit boards in addition to electrical connectors or conductors that pass through said materials. Organosiloxane gels for electronic applications are typically prepared from compositions containing high molecular weight polyorganosiloxanes. These materials are expensive and many applications would benefit from a gel having the desired properties but at a reduced cost. In addition, it is desirable to reduce the amount of gel that evaporates and to improve the gel's stability when exposed to high temperatures.

We have unexpectedly found that large amounts of a non-reactive silicone fluid can be added to a silicone gel without the fluid "bleeding out". The non-reactive silicone fluid also reduces the cost of the gel. Moreover, we have surprisingly found that such an addition reduces the weight loss of the gel over time and improves the heat aging properties of the gel as well. The resultant gels may be used as an encapsulant or pottant to protect electronic circuit boards or as a material useful for dampening vibrations.

U.S. Patent 5,145,933 describes organosiloxane gels that cure by a platinum-catalyzed hydrosilation reaction. Those curable compositions contain two different types of organohydrogensiloxanes and a polyorganosiloxane with vinyl group radicals located only on non-terminal silicon atoms. The first polydiorganosiloxane (1) contains silicon-bonded hydrogen atoms only at the terminal silicon atoms and the second polyorganosiloxane (2) has an average of at least three silicon-bonded hydrogen atoms per molecule, at least some of which are located on non-terminal silicon atoms. The percentage of the total silicon-bonded hydrogens contributed by polyorganosiloxane (1) is equal to 81.36 minus a factor equal to 3.6 times the molar ratio of all silicon-bonded hydrogen atoms, irrespective of source, to all alkenyl radicals present in our curable composition.

U.S. Patent 4,340,709 discloses organosiloxane compositions that also cure by a platinum-catalyzed hydrosilation reaction which further includes two types of organohydrogensiloxanes described in the previous patent. The molar ratio of the vinyl radicals present in the latter curable polyorganosiloxane to the silicon-bonded hydrogen atoms present in the organohydrogensiloxane (1) is from 0.75 to 1.5. While the viscosity of the vinyl-terminated curable polyorganosiloxane is from 100 to 200,000 centipoise (0.1 to 200 Pa·s) in this latter patent, the lowest viscosity disclosed in the exemplified compositions (Examples 2 and 3) is a mixture of 61.8 parts of a dimethylvinylsiloxy-terminated polydimethylsiloxane with a viscosity of 4,000 cps (4 Pa·s) and 5 parts of a dimethylvinylsiloxy-terminated polydimethylsiloxane with a viscosity of 0.5 Pa·s. In those compositions, the organohydrogensiloxane (1) contributes 70 and 74 percent, respectively, of the silicon-bonded hydrogen atoms present and the compositions contain a reinforcing silica filler. The curable compositions of Examples 2 and 3 had mixed viscosities of 40 and 85 Pa·s, respectively.

An objective of this invention is to provide curable organosiloxane compositions which contain a silicone fluid that does not "bleed" from the cured composition. The resultant gel is readily used as a pottant or encapsulant or as a material capable of dampening vibrations.

In accordance with the present invention, gels are prepared using compositions curable by a platinum-catalyzed hydrosililation reaction that are characterized by the presence of a non-reactive silicone fluid. This invention provides a curable organosiloxane composition comprising:
A. a first polyorganosiloxane having terminal siloxane units of the formula R¹R²₂SiO_{1/2} and non-terminal organosiloxane units of the formula R²₂SiO, where R¹ represents an alkenyl radical or a hydrogen atom and each R² is independently selected from R¹ or unsubstituted and substituted monovalent hydrocarbon radicals free of ethylenic unsaturation;
B. a polyorganosiloxane crosslinking agent containing an average of at least two silicon-bonded hydrogen atoms or alkenyl radicals per molecule, where the remaining silicon-bonded organic groups are monovalent hydrocarbon radicals selected from the same group as R² with the proviso that when the R¹ groups of ingredient A are alkenyl radicals, the crosslinking agent has at least two silicon-bonded hydrogen atoms and when the R¹ groups of ingredient A are silicon-bonded hydrogen atoms, the crosslinking agent has at least two alkenyl radicals;
C. an amount of a hydrosilation catalyst sufficient to promote curing of said composition; and
D. a non-reactive silicone fluid which comprises at least 25% by weight of the composition.

Our claimed gel may contain additional components and may also be formulated into a multi-part system.

The polyorganosiloxane (ingredient A) comprises a first polyorganosiloxane having terminal siloxane units of the formula R¹R²₂SiO_{1/2} and non-terminal organosiloxane units of the formula R²₂SiO where R¹ represents an alkenyl radical or a hydrogen atom and each R² is independently and individually selected from R¹ or unsubstituted and substituted monovalent hydrocarbon radicals free of ethylenic unsaturation.

This ingredient must contain on each terminal unit at least one silicon-bonded alkenyl radical, or in the alternative, at least one silicon-bonded hydrogen atom. Other alkenyl radicals or silicon-bonded hydrogen atoms can be present as pendent groups on the non-terminal units. It is preferred that ingredient A have alkenyl radicals rather than the silicon-bonded hydrogen atoms. Suitable alkenyl radicals contain from 1 to 10 carbon atoms and are exemplified by vinyl, allyl and 5-hexenyl. The silicon-bonded organic groups other than alkenyl radicals present in ingredient A are normally monovalent hydrocarbon or halogenated hydrocarbon radicals exemplified by alkyl radicals, such as methyl, ethyl and propyl; aryl radicals such as phenyl; and halogenated alkyl radicals such as 3,3,3-trifluoropropyl.

The molecular structure of ingredient A is typically linear; however, there may be some branching present due to the existence of trivalent siloxane units within the molecule. To achieve a useful level of tensile properties in our gels, prepared by curing these present compositions, the molecular weight of this ingredient must be sufficient to achieve a viscosity at 25°C. of greater than 0.05 Pa·s.

Preferred embodiments of ingredient A are polydiorganosiloxanes represented by the formula I 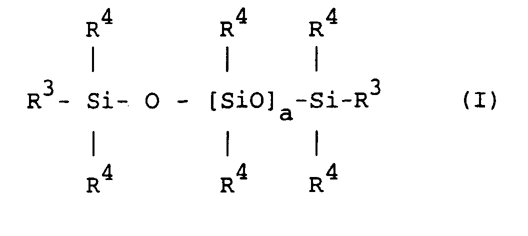 where each R³ is a vinyl or other monovalent ethylenically unsaturated hydrocarbon radical and R⁴ does not contain ethylenic unsaturation and is individually selected from monovalent hydrocarbon radicals or monovalent halohydrocarbon radicals and a represents a degree of polymerization (DP) equivalent to a viscosity of from 0.05 to 50 Pa·s. Preferably, a represents a DP equivalent to a viscosity of from 0.1 to 10 Pa·s, and most preferably, a viscosity of from 0.1 Pa·s to 5 Pa·s.

In our preferred embodiment, the substituents represented by R⁴ in formula I can be identical or different, contain from 1 to 20 carbon atoms and are free of ethylenic unsaturation. A range of from 1 to 10 carbon atoms is preferred based on the availability of the corresponding monomers. Most preferably, at least one of the hydrocarbon radicals on each silicon atom is methyl and any remainder are phenyl and/or 3,3,3-trifluoropropyl. This preference is based on the availability of the reactants usually employed to prepare the polydiorganosiloxane and the desired properties of cured gels prepared from such polydiorganosiloxanes. For the same reasons, R³ preferably contains from 2 to 10 carbon atoms and is most preferably vinyl or 5-hexenyl. While the preferred polymer does not have any pendant alkenyl groups, some small amounts may be present as a result of selected manufacturing processes, but excess amounts of pendant vinyl on the polymer will prevent the suitable formation of an acceptable gel.

Representative embodiments of ingredient A, containing ethylenically unsaturated hydrocarbon radicals only at the terminal positions, include dimethylvinylsiloxy-terminated polydimethylsiloxanes, dimethylvinylsiloxy-terminated polymethyl-3,3,3-trifluoropropylsiloxanes, dimethylvinylsiloxy-terminated-dimethylsiloxane/3,3,3-trifluoropropylmethylsiloxane copolymers and dimethylvinylsiloxy-terminated dimethylsiloxane/methylphenylsiloxane copolymers.

Methods for preparing ingredient A of our claimed compositions are by hydrolysis and condensation of the corresponding halosilanes or by equilibration of cyclic polydiorganosiloxanes which are sufficiently disclosed in patents and other literature that a detailed description in this specification is not necessary.

The present compositions contain a crosslinking agent with at least two silicon-bonded hydrogen atoms or alkenyl radicals per molecule. In the presence of a hydrosilation catalyst, ingredient C, the silicon-bonded hydrogen atoms of ingredient B undergo an addition reaction, referred to as hydrosilation, with the silicon-bonded alkenyl groups in ingredient A, resulting in crosslinking and curing of our composition. If ingredient A contains silicon-bonded hydrogen atoms, then the crosslinking agent must contain alkenyl radicals; so it reacts with a portion of the silicon-bonded hydrogen atoms present of ingredient A.

The silicon-bonded organic groups present in ingredient B are selected from the same group of monovalent hydrocarbon or halogenated hydrocarbon radicals as the organic groups of ingredient A. Preferred crosslinking agents will have at least three silicon-bonded hydrogen atoms. The molecular structure of ingredient B is typically straight chain, branch-containing straight chain, cyclic or network. The siloxane units of our crosslinking agent can exhibit the formulae R⁵_{b}SiO_{(4-b/2)}, where each R⁵ is individually selected from unsubstituted or substituted monovalent hydrocarbon radicals and b is 0, 1, 2 or 3. It is further understood that combinations of siloxane units containing different values of b can be present and that one of the R⁵ substituents represents hydrogen atom or alkenyl radical in at least two units of each molecule of the crosslinking agent. Units wherein b is 0 constitute up to 50 mole percent of the units present in the curing agent.

While the molecular weight of ingredient B is not specifically restricted, viscosities in the range of 0.5 to 2 Pa·s at 25°C. are preferred. Using a different batch of the same curable polydiorganosiloxane (ingredient A) with a slightly different concentration of vinyl radicals may substantially change the physical properties of our cured articles when operating close to the limits of the range for the molar ratio of silicon-bonded hydrogen atoms to vinyl radicals.

The concentrations of ingredients A and B required to optimize the desired properties are readily determined by routine experimentation with a knowledge of the present disclosure.

Our curable composition contains more than 0.3 and less than 1.3 moles of silicon-bonded hydrogen atoms per mole of alkenyl radicals. A preferred ratio is 0.4 to 1.1 and a most preferred ratio is 0.4 to 0.9.

The concentration of ingredient B is sufficient to provide the degree of crosslinking required to cure the organosiloxane composition. When ingredient B is a polyorganohydrogensiloxane, the molar ratio of silicon-bonded hydrogen atoms to the alkenyl radicals present in ingredient A is from 0.3 to 1.3.

A preferred crosslinking agent is a trimethylsiloxy-terminated polydiorganosiloxane having an average of five methylhydrogensiloxane units and three dimethylsiloxane units per molecule with a silicon-bonded hydrogen atom content of 0.7 to 0.8 weight percent.

The present compositions are cured by a hydrosilation catalyst that is a metal from the platinum group of the periodic table or a compound of such a metal. These metals include platinum, palladium and rhodium. Platinum and platinum compounds are usually preferred based on the high activity level of these catalysts in hydrosilation reactions.

Examples of preferred curing catalysts are platinum black, platinum metal on various solid supports, chloroplatinic acid, alcohol solutions of chloroplatinic acid and complexes of chloroplatinic acid with liquid ethylenically unsaturated compounds, such as olefins, and organosiloxanes containing ethylenically unsaturated hydrocarbon radicals bonded to silicon. Complexes of chloroplatinic acid with the aforementioned organosiloxanes containing ethylenically unsaturated hydrocarbon radicals are further described in U.S. Patent 3,419,593 which teaches preferred catalysts.

The concentration of ingredient C in our compositions is equivalent to a platinum group metal content of from 0.1 to 500 parts by weight of said metal, preferably from 1 to 50 parts by weight of said metal, per million parts (ppm), based on the combined weight of ingredients A and B.

Curing does not proceed satisfactorily at below 0.1 ppm of platinum group metal, while using more than 500 ppm results in no appreciable increase in cure rate and is, therefore, uneconomical.

The composition of the present invention includes non-reactive silicone fluids comprising oligomers and/or polymers having a formula selected from the group consisting of [(R)₂SiO]_{c} or (R)₃SiO-[(R)₂SiO]_{d}-Si(R)₃, where R is independently selected from the group consisting of alkyl groups, aryl groups and -[(R⁶)₂SiO]ₑ-R⁶ wherein R⁶ is alkyl or aryl, c is independently an integer of 2 to 10, e is an integer of 0 or greater and d is independently an integer of 0 or greater (preferably 0 to 1000). Preferably, R and R⁶ are each independently selected from the group consisting of C₁ to C₁₀ saturated linear hydrocarbon radicals, C₁ to C₁₀ saturated branched hydrocarbon radicals, C₆ to C₁₂ alkyl-substituted aromatic hydrocarbon radicals, C₃ to C₁₀ saturated cycloaliphatic hydrocarbon radicals, and combinations thereof. Most preferably, R and R⁶ are each independently selected from the group consisting of methyl, ethyl, n-propyl and isopropyl. These materials have been described in greater detail in "Chemistry and Technology of Silicones" by W. Knoll, Academic Press, 1968. Siloxanes comprise several structural classes all of which are useful herein: linear, branched and cyclic. Mixtures of the aforementioned are also useful herein. Many of the linear, branched and cyclic polysiloxanes have melting points below 25°C. Such materials are also commonly referred to as silicone liquids, silicone fluids or silicone oils.

The non-reactive silicone fluid will comprise at least 25% by weight of our composition, and preferably 25% to 85% by weight. A highly preferred range is 50 to 70% by weight.

The term "non-reactive silicone fluids" as used herein includes organosiloxanes, organosiloxane oligomers and polyorganosiloxanes. The term "non-reactive" means that the fluid does not contain groups that would react with either ingredients A or B under normal conditions. The general term "polyorganosiloxanes," is often shortened to "polysiloxanes" but both terms are used interchangeably herein. Useful non-reactive silicone fluids of this invention are those with silicon atoms exclusively bearing methyl groups. Any other silicone fluid having saturated hydrocarbon groups as substituents on the silicon atoms are also useful, providing their viscosities fall within the range described above and providing that said fluid is compatible with ingredients A and B. Such saturated hydrocarbon groups may be linear, branched or cyclic. Silicone fluids bearing organic groups that interfere with the cure of the claimed composition, such as hydrogen, halogen or alkoxy, are not useful and therefore not of the present invention.

Preferred non-reactive siloxane fluids of this invention include those of formula (II)

(R)₃SiO-[(R)₂SiO]_{d}Si(R)₃ (II)

wherein d is as previously denoted and R is independently selected from the group consisting of alkyl or aryl groups. Preferably, R is independently selected from the group of hydrocarbon radicals previously identified above. Most preferably, R is independently selected from methyl or phenyl radical.

Examples of specific linear siloxane fluids useful herein are the siloxane oligomers of the formula (IIa), commercially available from Dow Corning Corporation, Midland, Michigan, as "Dow Corning® 200 Fluids":

(CH₃)₃SiO-[(CH₃)₂SiO]_{d}Si-(CH₃)₃ (IIa)

wherein d is defined as above. These fluids are manufactured to yield essentially linear oligomers and/or polymers with average viscosities ranging from .00065 to 50 Pa·s. They are primarily linear in structure but can include cyclic and/or branched structures.

A more preferred range is from 0.025 to 10 Pa·s and a most preferred range is from 0.50 to 5 Pa-s. A preferred linear siloxane fluid d is an integer of 0 to 1500. A particularly preferred fluid has a viscosity of 0.350 Pa-s and is also commercially as a Dow Corning® 200 Fluid.

Examples of useful cyclic siloxanes of this invention include those of the formula (III) : 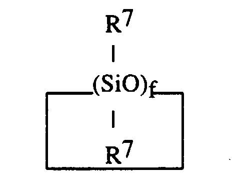 whrein f represents an integer of 3 to 9, preferably 4 to 7; and R⁷ is independently selected from alkyl or aryl groups. Preferably, R⁷ is independently selected from the group consisting of C₁ to C₁₀ saturated linear hydrocarbon, radicals, C₁ to C₁₀ saturated branched hydrocarbon radicals, C₆ to C₁₂ alkyl-substituted aromatic hydrocarbon radicals, C₃ to C₁₀ saturated cycloaliphatic hydrocarbon radicals and combinations thereof. Most preferably, R⁷ is independently selected from methyl or phenyl radical.

Examples of specific cyclic siloxanes useful for our invention is the cyclic polydimethylcyclosiloxanes of formula (IIIa) 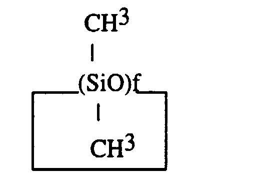 wherein f is as previously denoted. The most preferred cyclic siloxanes are those in which f is 4 to 5. These cyclic siloxanes are also known as octamethylcyclotetrasiloxane (commonly referred to as "D₄") or decamethylcyclopentasiloxane ("D₅"), respectively. They are also available from Dow Corning Corporation as Dow Corning® 244, 245, 344 and 345 Fluids, depending on their relative proportions of D₄ and D₅. Mixtures of the straight chain and cyclic dimethylsiloxanes are also useful in the present invention.

Useful branched siloxane fluids of the invention are those of (IV) and (V), 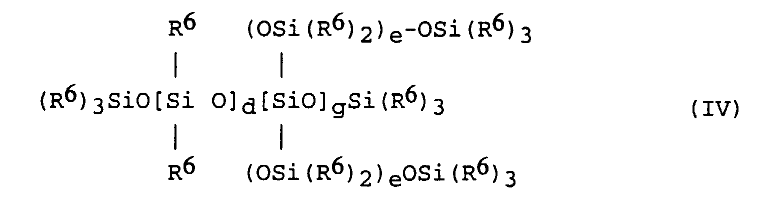 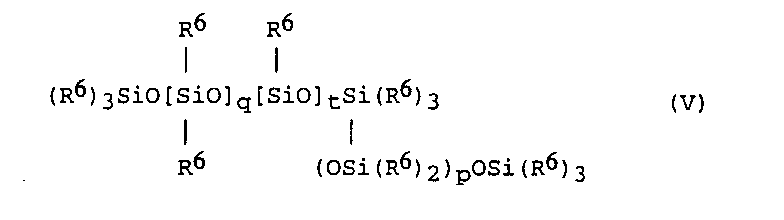 wherein each R⁶ is independently selected from alkyl or aryl groups; g represents an integer of from 1 to 5 and d and e independently represent an integer of 0 or greater, providing the branched polyorganosiloxane exhibits a viscosity within the ranges cited above and has a melting point below 25°C. and may be used in the liquid state as a reaction solvent. Preferably, R⁶ is independently selected from the group of hydrocarbons identified above for R⁶. Most preferably, R⁶ is independently selected from methyl or phenyl for formulas (IV) and (V).

Examples of useful branched polymers are those of the general formulas (IVa) and (Va): 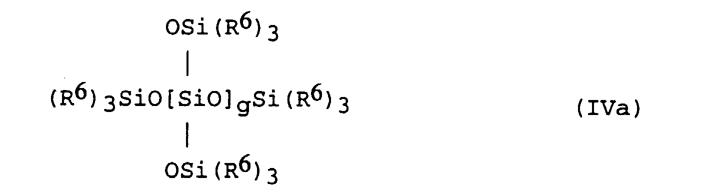 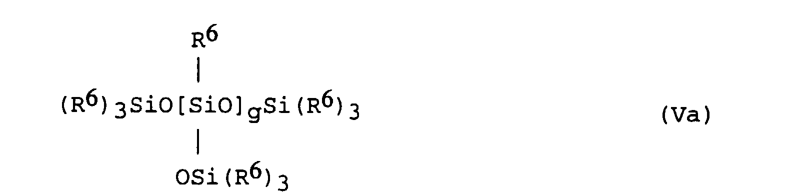 wherein R⁶ and g are as previously defined.

While the invention comprises the mixture of the ingredients A, B, C and D described above, it is contemplated that any siloxane based gel will benefit by the addition of our non-reactive silicone fluid. For example, the claimed fluid is conveniently added to the gels having chain extenders described in U.S. Patent 5,371,163. Other useful systems include gels described in U.S. Patents 4,100,627; 4,340,709; 4,824,390; 5,145,933 and 5,275,841 or JP Patent Publication 63/035654.

Mixtures of ingredients A, B, C and D may begin to cure at ambient temperature. To obtain a longer working time or "pot life", the activity of the catalyst under ambient conditions is adeptly retarded or suppressed by the addition of an inhibitor.

Known platinum catalyst inhibitors include the acetylenic compounds disclosed in U.S. Patent 3,445,420. Acetylenic alcohols, such as 2-methyl-3-butyn-2-ol, constitute a preferred class of inhibitors that will suppress the activity of a platinum-containing catalyst at 25°C. Compositions containing these catalysts normally require heating at temperatures of 70°C. or above to cure at a practical rate.

If desired to increase the pot life of a curable composition under ambient conditions, this can be accomplished using an alkenyl-substituted siloxane as described in U.S. Patent 3,989,667. Cyclic methylvinylsiloxanes are preferred.

Inhibitor concentrations as low as one mole of inhibitor per mole of platinum group metal will, in some instances, impart satisfactory storage stability and cure rate. In other instances, inhibitor concentrations of up to 500 or more moles of inhibitor per mole of platinum group metal are required. The optimum concentration for a given inhibitor in a given composition is readily determined by routine experimentation and does not constitute a part of this invention.

Some compositions may begin to cure under ambient conditions even when an inhibitor is present. One way to assure storage stability is to package the ingredients of the curable composition in two or more containers, with the hydrosilation catalyst and the organohydrogensiloxane in separate containers. The contents of the containers are then combined at the point of use when it is desired to cure the composition.

One-part organosiloxane compositions having excellent long-term storage stability at temperatures of up to 50°C. or higher are prepared by first microencapsulating the platinum group metal hydrosilation catalyst in a thermoplastic or thermosetting polymer. Curable organosiloxane compositions containing microencapsulated hydrosilation catalysts are more completely described in U.S. Patents 4,766,176 and 5,017,654. The teachings of these patents relate to storage stable one-part organosiloxane compositions which are useful herein. Suitable encapsulants include organosilicon resins or organic resins derived from ethylenically unsaturated hydrocarbons and/or esters of ethylenically unsaturated carboxylic acids such as acrylic and methacrylic acids.

To achieve high levels of tear strength and other physical properties for the cured elastomers that can be prepared from the compositions of this invention, it may be desirable to also include a reinforcing filler. Silica and other reinforcing fillers are often treated with one of more of the known filler treating agents to prevent a phenomenon referred to as "creping" or "crepe hardening" during processing of the curable composition.

Finely divided forms of silica are preferred herein as reinforcing fillers. Silicas are particularly preferred because of their relatively high surface area, which is typically at least 50 m²/g. Fillers having surface areas of at least 150 m²/g are especially preferred herein. Suitable silicas can be of the precipitated or fumed type. Both types of silica are commercially available

The amount of finely divided silica or other reinforcing filler used in the claimed compositions is at least in part determined by the physical properties desired for the cured elastomer. Liquid polyorganosiloxane compositions typically contain from 10 to 30 percent by weight of silica, based on the weight of polydiorganosiloxane. The amount of silica or other filler should not exceed the amount that increases the viscosity of the curable composition above 1000 Pa·s prior to cure.

The filler treating agent can be any of the low molecular weight organosilicon compounds disclosed in the art as suitable for preventing creping of organosiloxane compositions during processing. These treating agents are typically liquid hydroxyl terminated polydiorganosiloxanes containing an average of from 2 to 20 repeating units per molecule and organosilicon compounds such as hexaorganodisiloxanes and hexaorganodisilazanes that hydrolyze under the conditions used to treat the filler to form compounds with silicon-bonded hydroxyl groups. Preferably, at least a portion of the silicon-bonded hydrocarbon radicals present on the treating agent are identical to a majority of the hydrocarbon radicals present in ingredients A, B and C. A small amount of water can be added together with the silica treating agent(s) as a processing aid.

It is believed that the treating agents function by reacting with silicon-bonded hydroxyl groups present on the surface of the silica or other filler particles to reduce interaction between these particles and between polymer and filler.

When a silica filler is used, it is preferably treated in the presence of at least a portion of the other ingredients of the present compositions by blending these ingredients together until the filler is completely treated and uniformly dispersed to form a homogeneous material.

The ingredients that are present during treatment of the filler usually include the silica treating agents and at least a portion of the polydiorganosiloxane(s) referred to herein as ingredient A.

The present organosiloxane compositions can contain one or more additives that are conventionally present in curable compositions of this type to impart or enhance certain physical properties of the cured composition including improving adhesion or facilitating processing.

Typical additives include non-reinforcing fillers, such as quartz, alumina, mica and calcium carbonate; pigments such as carbon black or titanium dioxide; dyes, flame retardants, heat and/or ultraviolet light stabilizers.

The compositions of this invention are prepared by combining all of our ingredients at ambient temperature. Any of the mixing techniques and devices described in the prior art can be used for this purpose. The particular device used will be determined by the viscosity of the ingredients and the final curable composition. Suitable mixers are paddle mixers or kneader mixers. Cooling of the ingredients during mixing may also be desirable to avoid premature curing of our curable composition.

Our gels may be made in a multi-part system having two or more parts. In a typical preparation, a portion of the non-reactive silicone fluid, the cataylst and the first polysiloxane are mixed together as Part A and a second portion of the non-reactive silicone fluid, the crosslinking agent and the second polysiloxane are mixed together as Part B. When Parts A and B are then mixed together, a gel forms. Such a system contains any number of different parts, with different amounts of different ingredients. It is necessary, however, that the crosslinker and catalyst are not contained in the same part. Moreover, if the crosslinker contains silicon-bonded hydrogen atoms, or if the polysiloxane of ingredient A contains silicon-bonded hydrogen atoms, then ingredient A and the catalyst must be packaged in different parts.

The following examples demonstrate that a non-reactive silicone fluid can be added to a gel without "bleed out" and that the weight loss and high temperature aging (stability) of the gel is improved relative to gels without our non-reactive silicone fluid. Unless otherwise specified, all parts and percentages in the examples are by weight and all viscosities were measured at 25°C.

### Example 1

This example shows how a non-reactive silicone fluid is added to a silicone elastomeric gel composition without a tendency of the fluid to bleed out of the gel. To demonstrate the lack of bleed out, varying amounts of such silicone fluids of different viscosities were added to a particular gel composition and bleed out was monitored.

The gels were prepared from a two part composition. In each of the formulations below, Part A of the gel was made by mixing either 50, 60, 70 or 80 weight percent of non-reactive silicone fluid, 0.04 weight percent of platinum catalyst and 49.96, 39.96, 29.96 or 19.96 weight percent, respectively, of vinyl-terminated polydimethylsiloxane, having a viscosity of 0.45 Pa·s. The non-reactive silicone fluid was a methyl endblocked polydimethylsiloxane having viscosities of .05 Pa·s, 0.10 Pa·s, 0.35 Pa·s and 1.0 Pa·s, respectively, at 25°C. The hydrosililation catalyst was a platinum catalyst, which was a neutralized complex of platinous chloride and divinyltetramethyldisiloxane.

Part B was made by mixing either 50, 60, 70 or 80 weight percent of non-reactive silicone fluid and the respective amounts of crosslinker and the vinyl-terminated polydimethylsiloxane polymer above, as shown in Table 1. The crosslinker was a trimethylsiloxy-terminated polydiorganosiloxane, having an average of five methylhydrogensiloxane units and three dimethylsiloxane units per molecule, with a silicon-bonded hydrogen atom content of 0.7 to 0.8 weight percent. ("Crosslinker 1")

**Table 1 -**

| **Weight % Crosslinker and Vinyl Terminated Polydiorganosiloxane Added to Part B** | | | | |
|---|---|---|---|---|
| % Non-Reactive Silicone Fluid in Part B | Non-Reactive Silicone Fluid Viscosity | | | |
| | .05 Pa·s | 0.10 Pa·s | 0.35 Pa·s | 1.0 Pa·s |
| | Crosslinker/ Si-Vi | Crosslinker/ Si-Vi | Crosslinker/ Si-Vi | Crosslinker/ Si-Vi |
| 50% | 1.08 % / 48.92 % | 1.06 % / 48.94 % | 1.03 % / 48.97 % | 1.05% / 48.95% |
| 60% | 0.93 % / 39.07 % | 0.93 % / 39.07 % | 0.99 % / 39.01% | 0.97% / 39.03% |
| 70% | 0.77 % / 29.23 % | 0.77 % / 29.23 % | 0.82 % / 29.18 % | 0.85 % / 29.15% |
| 80% | 0.64 % / 19.36% | 0.64 % / 19.36% | 0.72 % / 19.28% | 0.69 % / 19.31% |

After Parts A and B were prepared as described above, 50% by weight of Part A was mixed with 50% by weight of Part B and stirred for one minute. 80 grams of each of the mixtures were then poured into six 118.3 ml (4 ounce) wide mouth jars, then heated to 50°C. for one hour. Afterwards, the mixtures were allowed to rest for 24 hours at room temperature.

The mixtures in each of the six jars were exposed to different temperatures. Two of the jars were heated to 125°C., two to 135°C. and two to 150°C. One jar in each set was heated with a lid screwed on, the other with the lid off. Visual observations of the gel in the jars were made and recorded in Table 2.

**Table 2 -**

| **Bleed Out of Cured Elastomer** | | | | |
|---|---|---|---|---|
| % Non-reactive Silicone Fluid in Parts A and B | Non-reactive Silicone Fluid Viscosity | | | |
| | .05 Pa·s | 0.10 Pa·s | 0.35 Pa·s | 1.0 Pa·s |
| 50% | OK at 500 hr. | OK at 500 hr. | OK 500 hr. | Wet out at 100 hr. |
| 60% | OK at 500 hr. | OK at 500 hr. | Slight oil at 100 hr. | Slight oil at 100 hr. Bleed at 300 hr. |
| 70% | OK at 500 hr. | Oily at 300 hr. | Oily at 200 hr. | Severe bleed at < 100 hr. |
| 80% | Very slight bleed at higher temps at 200 hr. | Slight bleed at high temps at <300 hr. | <200 hr. Bleed | Severe bleed at <100 hr. |
| "OK" = no bleed out | | | | |
| The above results substantiate that our elastomeric compositions can surprisingly include large amounts of non-reactive silicone fluid without the fluid bleeding out of the gel. | | | | |

### Example 2

The compositions of the present invention result in lower weight loss over time. The cured elastomeric compositions prepared in Example 1 were heated to a temperature of 150°C. for 500 hours and the weight loss was measured.

**Table 3 -**

| **Percent Weight Loss as a Function of Amount and Viscosity of Non-reactive Silicone Fluid** | | | | |
|---|---|---|---|---|
| % Non-reactive Silicone Fluid in Parts A and B | Non-reactive Silicone Fluid Viscosity | | | |
| | .05 Pa·s | 0.10 Pa·s | 0.35 Pa·s | 1.0 Pa·s |
| 50% | 0.59 | 0.54 | 0.50 | 0.50 |
| 60% | 0.49 | 0.41 | 0.41 | 0.50* |
| 70% | 0.39 | 0.31 | 0.41* | 0.49 * |
| 80% | 0.29 | 0.22 | 0.93* | 1.69 * |

| | | | | |
|---|---|---|---|---|
| * The bleed out observed on these identified samples impacted weight loss values. | | | | |

In contrast, gels prepared without our non-reactive silicone fluid showed much higher weight losses. A two part gel was prepared, where Part A was 99.3% by weight of vinyl-terminated polydimethylsiloxane, having a viscosity of 0.45 Pa·s and 0.7% by weight of a platinum catalyst, which was chloroplatinic acid complex of divinyltetramethyldisiloxane diluted with dimethylvinlysiloxy endblocked polydimethlysiloxane to provide 0.65 weight percent of platinum. Part B was 98.2% by weight of vinyl-terminated polydimethylsiloxane, having a viscosity of 0.45 Pa·s and 0.09% by weight of a methylvinyl cyclic, which was added as an inhibitor and 1.71% by weight of Crosslinker 1. A gel was prepared as described in Example 1 and a sample was heated at 150°C. for 2 hours. The weight lost for this gel was 2% of the composition; nearly four to eight times higher than the samples of this invention with our non-reactive silicone fluid described in Table 3.

### Example 3

The hardness of a gel containing non-reactive silicone fluid remains stable over longer periods of time, whereas the gel without said fluid hardens over time.

The gels were prepared from a two part composition. The first gel did not contain any of our non-reactive silicone fluid. Part A of the gel was made by mixing 1.2 g of a platinum catalyst, which was chloroplatinic acid complex of divinyltetramethyldisiloxane diluted with dimethylvinlysiloxy-endblocked polydimethlysiloxane to provide 0.65 weight percent of platinum and 300 g of vinyl-terminated polydimethylsiloxane, having a viscosity of 0.45 Pa·s. Part B of the first gel contained 294.9 g of vinyl-terminated polydimethylsiloxane, having a viscosity of 0.45 Pa·s and 5.1 g of Crosslinker 1 which was used as the crosslinking agent.

After Parts A and B were prepared as above, 50% by weight of Part A was mixed with 50% by weight of Part B and stirred for one minute. 80 grams of the mixtures were then poured into six 118.3 ml (4 ounce) wide mouth jars, then heated to 150°C. for one hour.

The second gel contained our non-reactive silicone fluid. Part A of the gel was made by mixing 1.2.g of a platinum catalyst, which was chloroplatinic acid complex of divinyltetramethyldisiloxane diluted with dimethylvinlysiloxy-endblocked polydimethlysiloxane to provide 0.65 weight percent of platinum and 300 g of methyl-endblocked polydimethylsiloxane, having a viscosity of 1.0 Pa·s. Part B of the first gel contained 296.1 g of vinyl terminated polydimethylsiloxane, having a viscosity of 0.45 Pa·s and 3.9 g. of Dow Corning® 6-3570 which was the crosslinking agent.

After the Parts A and B were prepared as described above, 50% by weight of Part A was mixed with 50% by weight of Part B and stirred for one minute. 80 grams of the mixtures were then poured into six 118.3 ml (4 ounce) wide mouth jars, then heated to 150°C. for one hour. Afterwards, the first and second gels were placed in an oven and heated to 177°C. The hardness of the gel was measured by measuring penetration. This was done on a Universal Penetrometer available from Precision Scientific, Chicago, Il. The measurements were made by placing the gel in the Penetrometer and lowering the penetration rod so that it just touched the surface of the gel. The release trigger was held for 5 seconds and the distance the penetration rod traveled was measured in tenths of a millimeter. The results are given in Table 4.

**Table 4 -**

| **Penetration of Heat Aged Gel over Time** | | |
|---|---|---|
| Hours at 177°C. | Penetration (mm x 10⁻¹) | |
| | 0 % Non-reactive Si Fluid | 50% Non-reactive Si Fluid |
| 0 | 48 | 33 |
| 170 | 44 | 37 |
| 525 | 42 | 36 |
| 864 | 43 | 34 |
| 2568 | 34 | 37 |

As the data in Table 4 illustrates, the gel without our non-reactive silicone fluid shows a penetration that drops to 34 after over 3 months of aging, while the penetration of a fluid containing gel of the present invention remains constant over the same period. This demonstrates that a gel with our non-reactive silicone fluid will not harden like the gel without such a fluid. The gels of the present invention thus have improved heat aging properties over gels without fluid.

## Claims

1. A curable organosiloxane composition comprising:
A. a first polyorganosiloxane having terminal siloxane units of the formula R¹R²₂SiO_{1/2} and non-terminal organosiloxane units of the formula R²₂SiO where R¹ represents an alkenyl radical or a hydrogen atom and each R² is independently and individually selected from R¹ or unsubstituted and substituted monovalent hydrocarbon radicals free of ethylenic unsaturation;
B. a polyorganosiloxane crosslinking agent containing an average of at least two silicon-bonded hydrogen atoms or alkenyl radicals per molecule, where the remaining silicon-bonded organic groups are monovalent hydrocarbon radicals selected from the same group as R², with the proviso that when the R¹ groups of polyorganosiloxane A are alkenyl radicals, the crosslinking agent has at least two silicon-bonded hydrogen atoms and when the R¹ groups of polyorganosiloxane A are silicon-bonded hydrogen atoms, the crosslinking agent has at least two alkenyl radicals;
C. an amount of a hydrosilation catalyst sufficient to promote curing of said composition; and
D. a non-reactive silicone fluid which is at least 25% by weight of said composition.

2. A multi-part composition comprising:
A. a first polyorganosiloxane having terminal siloxane units of the formula R¹R²₂SiO_{1/2} and non-terminal organosiloxane units of the formula R²₂SiO, where R¹ represents an alkenyl radical or a hydrogen atom and each R² is independently and individually selected from R¹ or unsubstituted and substituted monovalent hydrocarbon radicals free of ethylenic unsaturation;
B. a polyorganosiloxane crosslinking agent containing an average of at least two silicon-bonded hydrogen atoms or alkenyl radicals per molecule, where the remaining silicon-bonded organic groups are monovalent hydrocarbon radicals selected from the same group as R², with the proviso that when the R¹ groups of polyorganosiloxane A are alkenyl radicals, the crosslinking agent has at least two silicon-bonded hydrogen atoms and when the R¹ groups of polyorganosiloxane A are silicon-bonded hydrogen atoms, the crosslinking agent has at least two alkenyl radicals;
C. an amount of a hydrosilation catalyst sufficient to promote curing of said composition; and
D. a non-reactive silicone fluid which comprises at least 25% by weight of the composition; with the proviso that when the crosslinking agent contains silicon-bonded hydrogen atoms, the crosslinking agent and hydrosilation catalyst are in separate parts and when the polysilioxane A contains silicon-bonded hydrogen atoms, polysiloxane A and the hydrosilation catalyst are in separate parts.

3. A composition according to claim 1 wherein R¹ on the terminal siloxane units for polyorganosiloxane A is vinyl and R² on the non-terminal siloxane units are selected from unsubstituted and substituted monovalent hydrocarbon radicals free of ethylenic unsaturation and the crosslinking agent in crosslinking agent B has silicon-bonded hydrogen atoms.

4. A composition according to claims 1 or 2, wherein polyorganosiloxane A is a vinyl-terminated polydimethylsiloxane having a viscosity of 0.45 Pa·s, crosslinking agent B is a methyl-endblocked siloxane polymer having a degree of polymerization of eleven and six silicon-bonded hydrogen units, hydrosilation catalyst C is a platinum catalyst and non-reactive silicone fluid D is a methyl endblocked polydimethylsiloxane having a viscosity of from 0.00065 to 50 Pa·s.

5. A composition according to any of the preceding claims 1 - 4 wherein the viscosity of polyorganosiloxane A is between 0.05 and 50 Pa·s.

6. A composition according to claim 1 wherein the non-reactive silicone fluid is present in an amount of 25 to 85 percent by weight of the composition.

7. The composition according to claim 1 wherein the molar ratio of silicon-bonded hydrogen atoms to alkenyl groups is 0.3 to 1.3.

8. An organosiloxane gel obtainable by curing the composition of any of claims 1 - 7.

9. Use of the composition of any of claims 1 - 7 as a pottant or encapsulant on a printed circuit board or an electronic component.
